# EUROPEAN PATENT SPECIFICATION

(11) **EP 4 068 353 B1**
(45) Date of publication and mention of the grant of the patent: **27.12.2023**
(21) Application number: 21166374.5
(22) Date of filing: 31.03.2021
(51) Int. Cl.: H01L 25/07, H01L 23/051, H01L 21/60

(54) **METHOD FOR PRODUCING A POWER SEMICONDUCTOR MODULE AND POWER SEMICONDUCTOR MODULE**
VERFAHREN ZUR HERSTELLUNG EINES LEISTUNGSHALBLEITERMODULS SOWIE LEISTUNGSHALBLEITERMODUL
PROCÉDÉ DE FABRICATION D'UN MODULE SEMICONDUCTEUR DE PUISSANCE ET MODULE SEMICONDUCTEUR DE PUISSANCE

(43) Date of publication of application: 05.10.2022
(73) Proprietor: Hitachi Energy Ltd, 8050 Zürich (CH)
(72) Inventor: LIU, Chunlei, 5452 Oberrohrdorf (CH); SALVATORE, Giovanni, 34170 Gorizia (IT); SCHUDERER, Jürgen, 8047 Zürich (CH); MOHN, Fabian, 5408 Ennetbaden (CH)
(74) Representative: Epping - Hermann - Fischer

(56) References cited:
- EP-A1- 3 627 548
- EP-A1- 3 739 624
- CN-B- 108 231 703
- CN-B- 108 281 405
- US-A1- 2013 050 947
- US-A1- 2014 151 009
- US-A1- 2020 152 595
- US-A1- 2020 279 791

## Description

The present disclosure relates to a method for producing a power module, a method for producing a flexible structure and a power module.

A power module includes a power semiconductor body which is located between a first plate and a second plate. For example, a spring is arranged between the second plate and the power semiconductor body. Pressure may be applied to achieve a good electrical contact between the second plate and a first surface of the power semiconductor body via the spring. The spring is designed to fit to the first surface of the power semiconductor body. However, such a spring cannot easily be downscaled to fit to a smaller power semiconductor body.

Document US 6320268 B1 refers to a power semiconductor module with a semiconductor chip with which contact is made by pressure. A contact element has two planar contact surfaces between which a spring element is located.

Document US 2020/0152595 A1 is related to a spring electrode for a press-pack power semiconductor module.

Document US 2019/0229030 A1 relates to a power module and method for producing a power module.

Document CN 108 281 405 B relates to a power device module and preparation method thereof.

Document EP 3 627 548 A1 relates to a semiconductor module and a method for manufacturing a semiconductor module. The semiconductor module comprises a stack having, in this order, a first cooling member, a semiconductor elements, a block member, several spring members, and a second cooling member. Document US 2014/151009 A1 relates to a thermal interface element. Document US 2013/050947 A1 relates to a power module, a method for manufacturing a power module and a molding die.

There is a need for a method for producing a power module, a method for producing a flexible structure and a power module.

The invention is defined by the independent claims. Advantageous embodiments and further developments are subject of the dependent claims.

According to an embodiment of the claimed invention, the method for producing a power module comprises providing a first plate, providing a second plate, arranging a first number N of power semiconductor bodies on the first plate, providing a first number N of preforms, providing a first number N of flexible structures, and forming a stack comprising, in this order, the first plate, the first number N of power semiconductor bodies, the first number N of preforms, the first number N of flexible structures and the second plate, wherein the first number N of flexible structures is additive manufactured on the first number N of preforms, wherein the first number N is greater than 1 and wherein the first number N of flexible structures are configured to compensate height differences of the first number N of the power semiconductor bodies.

Advantageously, the first number N of flexible structures can be designed to fit to power semiconductor bodies having a first surface with a small area or a large area. Additive manufacturing is a versatile tool to produce the first number N of flexible structures with appropriate diameter and appropriate flexibility.

Additive manufacturing may also be named 3-D printing or 3D printing.

According to a further embodiment, additive manufacturing is performed using one of the following technologies: Fused Deposition Modeling (abbreviated FDM), Selective Laser Sintering (abbreviated SLS), Selective Laser Melting (SLM), Electronic Beam Melting (abbreviated EBM), additive manufacturing for metal structures or another additive manufacturing technology.

According to an embodiment , which does not form part of the claimed invention, a method for producing a flexible structure comprises additive manufacturing of a first number N of flexible structures. The first number N of flexible structures are configured for a power module. The method for producing a flexible structure described in this disclosure are exemplarily suitable for the method for producing a power module. Features and advantages described in connection with the method for producing a flexible structure can therefore be used for the method for producing a power module and vice versa.

According to an embodiment of the claimed invention, the power module comprises a stack comprising, in this order, a first plate, a first number N of power semiconductor bodies, a first number N of preforms, a first number N of flexible structures and a second plate, wherein the first number N of flexible structures is additive manufactured on the first number N of performs, wherein the first number N is greater than 1, and wherein the first number N of flexible structures are configured to compensate height differences of the first number N of the power semiconductor bodies.

The first number N of flexible structures are produced by additive manufacturing. Thus, the first number N of flexible structures are implemented as first number N of additive manufactured flexible structures.

Advantageously, by the first number N of flexible structures a pressure can be applied from the second plate to the first number N of power semiconductor bodies in case of small power semiconductor bodies and also in case of large power semiconductor bodies.

In an example, a flexible structure is realized as a deformable structure. Thus, the first number N of flexible structures are produced as first number N of deformable structures.

Parts such as the flexible structures which are made by additive manufacturing can be distinguished from parts made by other technologies such as metalworking - milling, turning, threading, grinding, filing, welding, brazing, wire drawing etc. - and injection molding. Parts which are made by additive manufacturing can be recognized by checking the inner structure of the parts and/or the surface of the parts. Parts which are made by additive manufacturing typically have a higher roughness of the surface and an inner structure with cavities or a porosity which can be seen using an optical microscope or an electron microscope (e.g. looking at a surface or a cross section of a part).

In an example, exactly one flexible structure of the first number N of flexible structures is arranged between one of the first number N of power semiconductor bodies and the second plate. The flexible structure comprises or consist of a number P of parts. The number P is less than 10 or less than 5. The number P is e.g. one or two. Thus, one flexible structure realized by additive manufacturing is assembled from much less parts in comparison to a flexible structure that is not manufactured by additive manufacturing but is formed by many individual parts assembled together.

The method for producing a power module and the method for producing a flexible structure described above are exemplarily suitable for the power module. Features and advantages described in connection with the power module can therefore be used for the method for producing a power module and for the method for producing a flexible structure and vice versa.

In an example, the first number N of flexible structures are 3D printed parts. In an example, which is not covered by the claimed invention, The first number N of flexible structures are directly printed on a plate, e.g. on the second plate, as a single part unit. Advantageously, it can be avoided that many small parts are assembled together later.

According to a further embodiment, the power module incorporates a flexible structure that is realized as a 3D printed press-pin. The power module may be implemented as a press-pack power module. The 3D printed press-pin realizes a 3D printed height compensator.

According to a further embodiment, an arrangement comprises series connected modules, e.g. in high-voltage, direct current applications (abbreviated HVDC applications) or in flexible AC transmission systems, abbreviated FACTS, e.g. with failure-tolerant capability. The power module includes a press-pin with height compensation enabled by additive manufacturing, which can be named 3D printing. Advantageously, the power module can be produced at reduced cost. The power module is implemented as high current power module with SiC chip. The power module realizes a rigid press-pack also for high current with a robust package for an HVDC application, for example with small SiC chips. The proposed spring of the power module can be scaled downward to fit small SiC chips. The costs for the proposed power module can be reduced due to low part counts and low number of assembly processes.

According to a further embodiment, a second plate can be implemented as top emitter plate or top emitter/source plate. The 3D printed height compensator enables a single-part spring array (e.g. Inconel 718 or high strength Cu alloy) direct on the second plate (or a preform) with accurate alignment to chip position. The second plate or the metal preform can be realized with 3D printed spring structure for homogenous pressure distribution and close the arcing gap after chip failure, e.g. in a short-circuit-failure-mode capability, abbreviated SCFM capability. This increases the power cycling capability or product lifetime. The second plate supports or carries an array of 3D printed springs which are aligned to the SiC chip position. Alternatively, the top metal preform is attached to a 3D printed height compensator for each individual SiC chip. The power module can be implemented as bipolar and/or metal-oxide-semiconductor module (abbreviated Bipolar/MOS module). The power semiconductor bodies are produced e.g. as insulated gate bipolar transistors, abbreviated IGBT.

The accompanying figures are included to provide a further understanding. In the figures, elements of the same structure and/or functionality may be referenced by the same reference signs. It is to be understood that the embodiments shown in the figures are illustrative representations and are not necessarily drawn to scale.
Figures 1, 2 and 4 are cross-sections of power modules presented for illustration purposes only;
Figure 3 is a cross-section of a power module according to an embodiment of the claimed invention;
Figures 5A and 5B are flexible structures according to different embodiments;
Figure 6 is a cross-section of an arrangement according to an embodiment; and
figures 7A and 7C are methods for fabricating a power module presented for illustration purposes only;
Figure 7B is a method for fabricating a power module according to an embodiment.

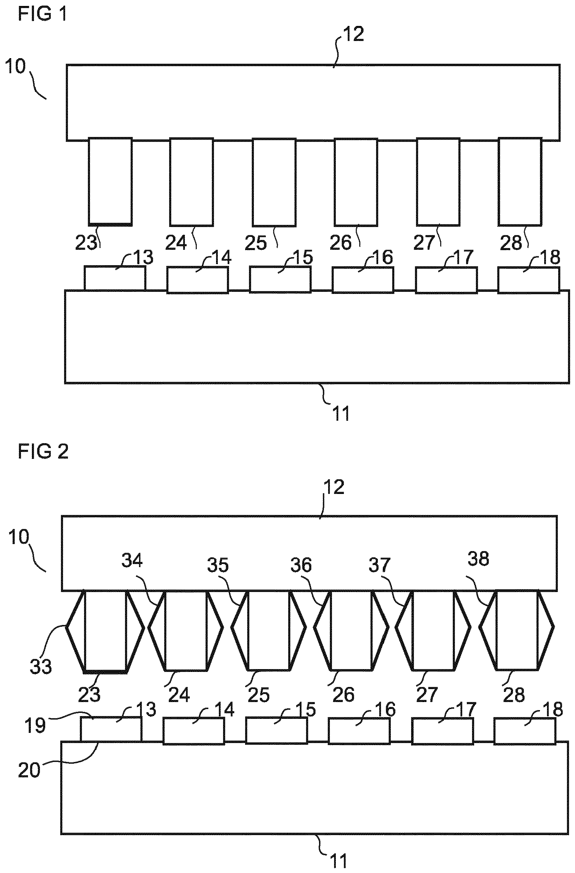

Figure 1 shows a cross-section of a power module 10. The power module 10 comprises a first and a second plate 11, 12 and a first number N of power semiconductor bodies 13 to 18.

The first plate 11 can be named base plate. The second plate 12 can be named top emitter plate or emitter plate. Moreover, the power module 10 comprises a first number N of flexible structures 23 to 28. In Figure 1, the power module 10 is shown before a stack is formed. After forming the stack, the first number N of power semiconductor bodies 13 to 18 are attached on the first plate 11, the first number N of flexible structures 23 to 28 are attached on the first number N of power semiconductor bodies 13 to 18 and the second plate 12 is attached on the first number N of flexible structures 23 to 28. The stack of the power module 10 has this order: the first plate 11/the first number N of power semiconductor bodies 13 to 18/the first number N of flexible structures 23 to 28/the second plate 12.

A power semiconductor body 13 has a first and a second surface 19, 20. The first surface 19 of the power semiconductor body 13 is oriented towards the second plate 12, whereas the second surface 20 of the power semiconductor body 13 is oriented towards the first plate 11. The first plate 11 is made from a homogenous material which is a metal, such as e.g. copper or molybdenum. The second plate 12 is made from a homogenous material which is a metal, such as e.g. copper or molybdenum.

The first number N of flexible structures 23 to 28 has e.g. a cylinder form. The first number N of flexible structures 23 to 28 are produced as porous structures or hollow structures by additive manufacturing. The first number N of flexible structures 23 to 28 are produced by additive manufacturing on the second plate 12. The first number N of flexible structures 23 to 28 are produced by additive manufacturing using an electrically conductive material which is e.g. a metal or a metal alloy. The metal alloy is e.g. a Cu alloy, e.g. a CuNiSi alloy. Thus, the first number N of flexible structures 23 to 28 realize both a spring function and an electrical function.

The first number N of power semiconductor bodies 13 to 18 are produced using silicon or a wide band gap semiconductor as a substrate, such as e.g. silicon carbide, abbreviated SiC. An area of a power semiconductor body of the first number N of semiconductor bodies 13 to 18 is less than 100 mm², alternatively less than 50 mm² or less than 25 mm². A power semiconductor body 13 can be named as power semiconductor device or power semiconductor chip. For example, a flexible structure of the first number N of flexible structures 23 to 28 is porous or hollow or has some fine structures which allow flexibility in the direction from the first plate 11 to the second plate 12.

In the example shown in Figure 1, the first number N of flexible structures 23 to 28 are attached to the second plate 12 before forming the stack. Thus, the first number N of flexible structures 23 to 28 are produced on the second plate 12. Also before forming the stack or at one of the first processes for forming the stack, the first number N of power semiconductor bodies 13 to 18 are attached to the first plate 11, e.g. by a not shown material such as a glue or a solder. The first number N of flexible structures 23 to 28 are attached or oriented e.g. to a center of the first surface 19 of the first number N of power semiconductor bodies 13 to 18.

Advantageously, the first number N of flexible structures 23 to 28 are configured to compensate height differences of the first number N of the power semiconductor bodies 13 to 18.

The height differences may result from a variation of a thickness of the first number N of power semiconductor bodies 13 to 18 and/or from a variation of a thickness of the material which fixates the first number N of power semiconductor bodies 13 to 18 to the first plate 11. The power module 10 is height tolerant. The first number N of flexible structures 23 to 28 allow some travel distance.

The power module 10 achieves a homogenous pressure distribution for multi-chips. The power module 10 is designed as a high-current and robust package for HVDC applications. A flexible structure 23 has a diameter that fits to a power semiconductor body 13, even in case the power semiconductor body 13 is small, e.g. has an area of 5 mm times 5 mm. As shown in Figure 1, the power module 10 includes a 3D printed conductive spring array that realizes the first number N of flexible structure 23 to 28.

Figure 2 is a cross-section of a power module 10 which is a further development of the one shown in Figure 1. The power module 10 includes a first number N of conducting parts 33 to 38. A conducting part 33 couples one end of a flexible structure 23 to the other end of the flexible structure 23. Thus, after attachment and forming the stack, the first surface 19 of the power semiconductor body 13 is electrically connected via the conducting part 33 to the second plate 12. Consequently, the first number N of conducting parts 33 to 38 electrically connect the first number N of semiconductor bodies 13 to 18 to the second plate 12. The first number N of conducting parts 33 to 38 are arranged in the stack and provide an electrical conducting path from the second plate 12 to the power semiconductor bodies 13 to 18. The first number N of conducting parts 33 to 38 are made of metal, e.g. copper.

The first number N of flexible structures 23 to 28 can be made out of a conductive material (as shown in Figure 1) or out of a non-conductive material (as shown in Figure 2). The first number N of flexible structures 23 to 28 are produced by additive manufacturing using non-conductive material. Non-conductive material includes a material which is not electrically conductive or a material with low electrical conductivity.

The first number N of flexible structures 23 to 28 are produced by using e.g. an austenitic nickel-chromium-based alloy or austenitic chromium-based superalloy, for example Inconel alloys or Inconel alloy 718. Inconel is a trade mark of Special Metals Corporation, New Hartford, New York, U.S.A.. Inconel alloys are provided by Special Metals Corporation. The first number N of flexible structures 23 to 28 can be made out of Inconel alloys and Inconel alloy 718 by additive manufacturing. Inconel has in general a low electrical conductivity.

As shown in Figure 2, the power module 10 includes a 3D printed spring array with additional current path. Advantageously, additive manufacturing enables a single-part spring (e.g. Inconel 718, Cu alloy) direct on the second plate 12 (or a preform shown below) with accurate position. The part counts for a press-pack power module press-pin is reduced. A smaller spring is possible for smaller chip size (e.g. SiC or other wide band gap semiconductor). The power module 10 results in reduced part counts (e.g. 10-20 times less part counts) and cost for a press-pack power module press-pin kit. The spring materials, size, geometry and properties can be optimized.

The first number N of flexible structures 23 to 28 may be made of an electrically conductive material and the power module 10 includes the first number N of conducting parts 33 to 38. Thus, first number N of conducting parts 33 to 38 provide an additional electrical path from the first number N of power semiconductor bodies 13 to 18 to the second plate 12.

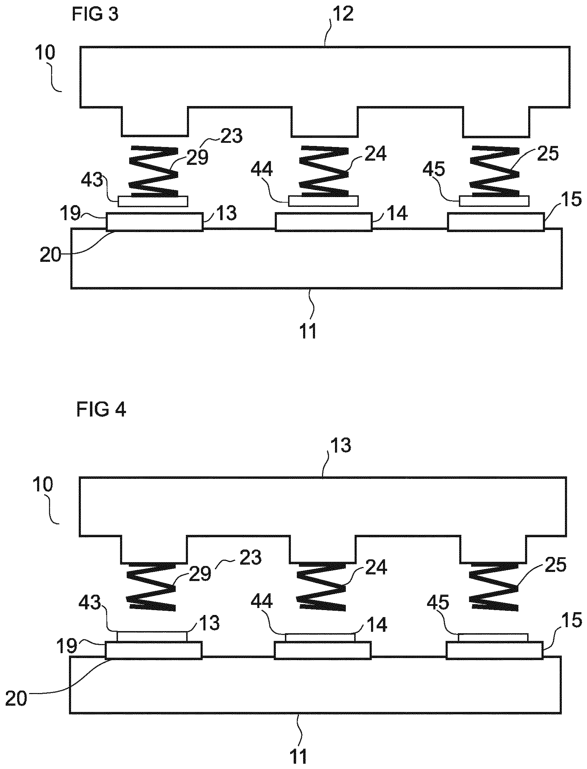

Figure 3 is a cross-section of a power module 10 according to an embodiment of the claimed invention. The power module 10 of figure 3 is a further development of the power module shown in Figures 1 and 2. The first number N of flexible structures 23 to 25 are realized as springs 29. Thus, each flexible structure of the first number N of flexible structures 23 to 25 is fabricated as a spring 29. The power module 10 additionally comprises a first number N of preforms 43 to 45. The first number N of preforms 43 to 45 are located between the first number N of power semiconductor bodies 13 to 15 and the first number N of flexible structures 23 to 25. The first number N of flexible structures 23 to 25 are arranged on the first number N of preforms 43 to 45. The first number N of flexible structures 23 to 25 are fabricated on the first number N of preforms 43 to 45. The first number N of preforms 43 to 45 are designed to fit to the first number N of power semiconductor bodies 13 to 15. The stack further comprises the first number N of preforms 43 to 45. The stack is formed such that the stack comprises the first plate 11, the first number N of power semiconductor bodies 13 to 15, the first number N of preforms 43 to 45, the first number N of flexible structures 23 to 25 and the second plate 12. The stack of the power module 10 has this order: the first plate 11/the first number N of power semiconductor bodies 13 to 15/the first number N of preforms 43 to 45/the first number N of flexible structures 23 to 25/the second plate 12.

The first number N of preforms 43 to 45 is made of a conductive material, such as metal. The first number N of flexible structures are produced by additive manufacturing on the first number N of preforms.

In Figure 3, the power module 10 is shown before forming the stack. The first number N of power semiconductor bodies 13 to 15 are attached to the first plate 11. The stack is formed such that the first number N of flexible structures 23 to 25, which are already produced on the first number N of preforms 43 to 45, are attached to the first surface 19 of the first number N of semiconductor bodies 13 to 15. The second plate 12 is attached to the first number N of flexible structures 23 to 25. In Figure 3, a preform 43 with 3D printed spring structure is shown. The preform 43 carries the height compensator.

In an example (e.g. in case the first number N of flexible structures 23 to 25 are made out of non-conductive material), the first number N of conducting parts 33 to 35 are arranged in the stack to electrically connect the second plate 12 to the first number N of semiconductor bodies 13 to 15 or to the first number N of preforms 43 to 45.

Figure 4 is a cross-section of a power module 10. As shown in Figure 4, the first number N of preforms 43 to 45 are attached to the first number N of power semiconductor bodies 13 to 15. The first number N of preforms 43 to 45 are attached to the first surface 19 of the first number N of power semiconductor bodies 13 to 15. The first number N of flexible structures 23 to 25 are attached to the second plate 12. Thus, for example, the first number N of flexible structures 23 to 25 are fabricated on the second plate 12.

Thus, a stack is formed by attaching the second plate 12 together with the first number N of flexible structures 23 to 25 on one side to a stack of the first number N of preforms 43 to 45, the first number N of the power semiconductor bodies 13 to 15 and the first plate 11 on the other side. The second plate 12 includes bumps or elevations at which the first number N of flexible structures 23 to 25 are attached.

In Figure 4, the second plate 12 carries a 3D printed spring structure. Thus, the second plate 12 supports the height compensator. The power module 10 of Figures 1 to 4 can be implemented in a press-pack power module or a press-pack type module in a hermetic sealed ceramic housing (not shown).

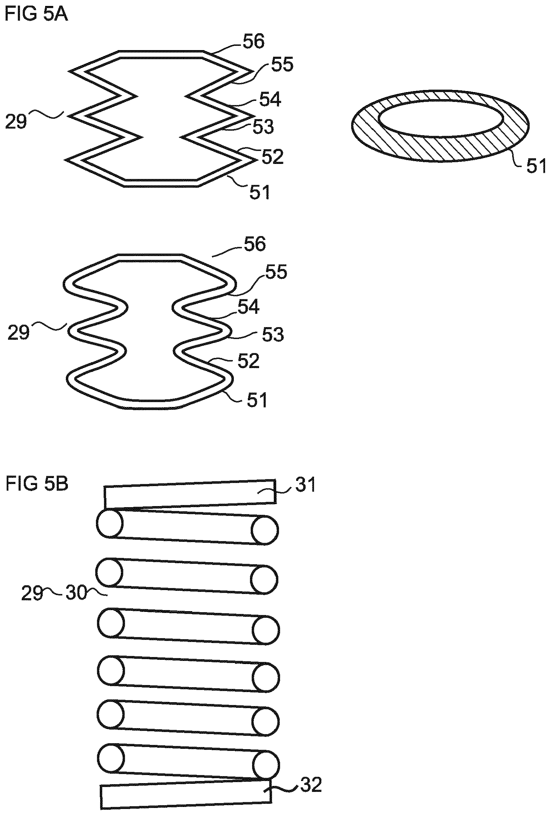

Figure 5A is a flexible structure 23 according to an embodiment which is a further development of the embodiments shown above. The flexible structure 23 is realized as a spring 29. The first number N of flexible structures 23 to 28 are produced as springs 29 by additive manufacturing. The springs 29 have a form of a group comprising a coil (as shown e.g. in Figures 3, 4 and 5B) and a stack of spring washers 51 to 56 (as shown e.g. in Figure 5A).

The spring 29 has the form of a stack of a second number M of spring washers 51 to 56. The second number M is e.g. larger than one or larger than 10. A single spring washer 51 is also shown in Figure 5A. Since the spring washer 51 is not flat, it has the effect of a spring. A spring washer 51 can also be implemented as a Belleville washer, cupped spring washer, conical spring washer, disc spring washer, curved disc spring, waver washer and/or wave spring. The flexible structure 23 is produced by additive manufacturing; thus, the spring 29 is not realized out of several single and separate spring washers. Instead, the flexible structure 23 is fabricated as a single part. In Figure 5A, a spring 29 with rounded shape and a spring 29 with corners and edges are shown.

Figure 5B is a cross section of a flexible structure 23 according to an embodiment which is a further development of the embodiments shown above. The flexible structure 23 is realized as a coil 30. Optionally, the flexible structure 23 has a first end plate 31 which is configured for attachment to the second plate 12. Also optionally the flexible structure 23 includes a second end plate.

In Figures 5A and 5B, examples of one flexible structure 23 are shown. The other flexible structures of the first number N of flexible structures 23 to 28 are realized such as the flexible structure 23. Other designs which can be realized by additive manufacturing can be used for the fabrication of the first number N of flexible structures 23 to 28.

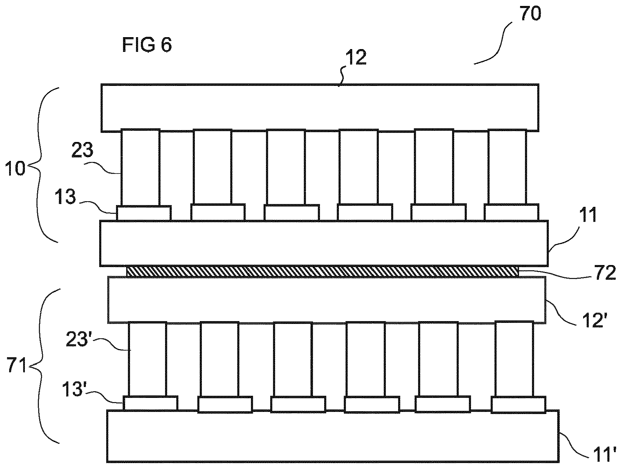

Figure 6 is a cross-section of an arrangement 70 according to an embodiment which is a further development of the above-shown embodiments. The arrangement 70 comprises a third number L of power modules 10, 71. The power modules 10, 71 can be realized such as the power module 10 shown in Figures 1 to 4. A further power module 71 comprises a further first and a further second plate 11', 12', a further number N of power semiconductor bodies 13' and a further number of flexible structures 23'. The first number N may be equal or different from the further number. The third number L of power modules 10, 71 form a stack. The third number L is larger than 1 or larger than 4. A fixation layer 72 fixates the power module 10 to the adjacent power module 71. The fixation layer 72 may be a solder or glue.

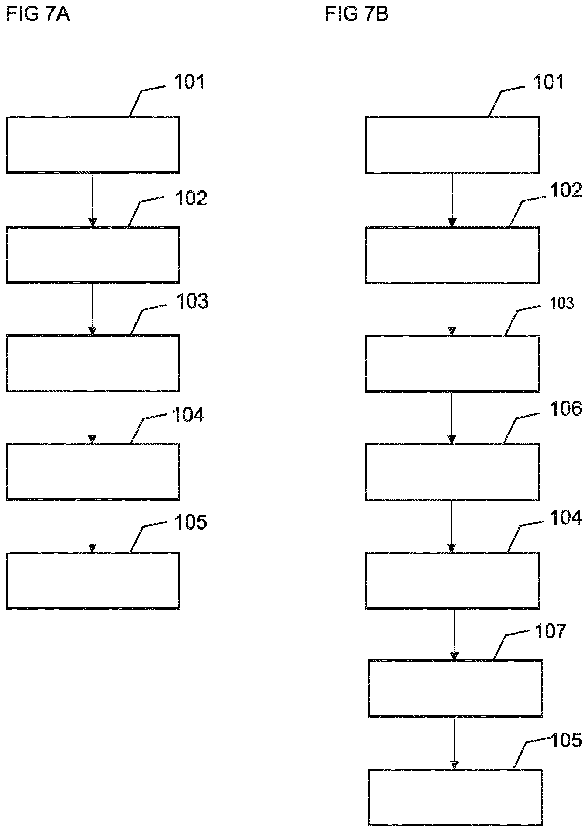

Figure 7A shows a method, which does not form part of the claimed invention, for fabricating a power module 10. The method includes a first providing process 101, a second providing process 102, an arrangement process 103, an additive manufacturing process 104 and a stack forming process 105. In one example, the processes are performed in an order as shown in Figure 7A and written above. Alternatively, the chronological order of some of the processes is interchanged.

In the first providing process 101, the first plate 11 is provided. In the second providing process 102, the second plate 12 is provided. In the arrangement process 103, the first number N of power semiconductor bodies 13 to 18 are attached on the first plate 11, e.g. by solder or glue. In the additive manufacturing process 104, the first number N of flexible structures 23 to 28 are fabricated by additive manufacturing. In the stack forming process 105, the stack is formed comprising the second plate 12, the first number N of flexible structures 23 to 28, the first number N of power semiconductor bodies 13 to 18 and the first plate 11.

The additive manufacturing process 104 is realized e.g. such that the first number N of flexible structures 23 to 28 are produced on the second plate 12 by additive manufacturing. Alternatively, the additive manufacturing process 104 is realized such that the first number N of flexible structures 23 to 28 are produced on the first number N of power semiconductor bodies 13 to 18 by additive manufacturing.

Figure 7B shows an embodiment according to the claimed invention of a method for producing a power module 10. According to Figure 7B, the method includes a third providing process 106. In the third providing process 106, the first number N of preforms 43 to 45 are provided. Additionally, the method includes an attachment process 107. In the attachment process 107, the first number N of preforms are attached to the first surface of the first number N of power semiconductor bodies 13 to 15.

The first number N of flexible structures 23 to 25 are produced on the first number N of preforms 43 to 45 such as shown in Figure 3. After these processes, the stack is formed by the stack forming process 105, wherein the first number N of preforms 43 to 45 together with the first number N of flexible structures 23 to 25 are first attached to the first surface 19 of the first number N of power semiconductor bodies 13 to 15 and then the second plate 12 is attached to the first number N of flexible structures 23 to 25.

In an alternative which does not form part of the claimed invention, in the additive manufacturing process 104, the first number N of flexible structures 23 to 25 are produced on the second plate 12 by additive manufacturing. Thus, as shown in Figure 4, the second plate 12 and the first number N of flexible structures 23 to 25 are attached to a stack comprising the first number N of preforms 43 to 45, the first number N of power semiconductor bodies 13 to 15 and the first plate 11 in the stack forming process 105.

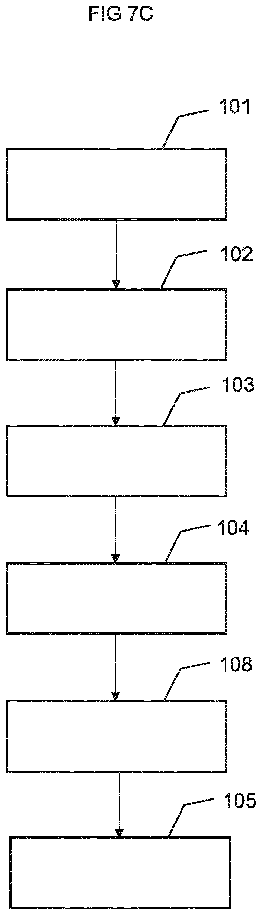

Figure 7C shows another embodiment, which does not form part of the claimed invention, of a method for producing a power module 10 which is a further development of the above-shown embodiments. The method includes providing a fixation process 108. In the fixation process 108, the first number N of conducting parts 33 to 38 are provided and attached to the first number N of flexible structures 23 to 28. The further processes can be performed as described above. The method comprises providing a first number N of conducting parts which are arranged in the stack to connect the second plate to the first number N of semiconductor bodies or to the first number N of preforms. The first number N of conducting parts 33 to 38 are fabricated by additive manufacturing or by another process. Additive manufacturing is performed using different materials for the first number N of flexible structures 23 to 28 and for the first number N of conducting parts 33 to 38. The first number N of flexible structures 23 to 28 are fabricated e.g. with multi-metal printing which is done within one single step. The first number N of flexible structures 23 to 28 are fabricated e.g. with additive manufacturing as a first step and with electroplating as the second step.

Optionally, the method comprises arranging the third number M of power modules 10, 71 on top of each other, e.g. as shown in Figure 6.

The methods as illustrated in Figures 7A to 7C can be combined. The chronical order is shown in Figures 7A to 7C. The chronical order of the processes can be changed.

The power module 10 realizes a press-pack power module with 3D printed spring / height compensator for homogenous pressure distribution among multiple power semiconductor bodies 13 to 18 or chips in parallel. The power semiconductor bodies 13 to 18 or chips are made of Si or a wide-band gap semiconductor such as SiC. The springs/height compensator are 3D printed on a common second plate 12 which are aligned to the chip positions. Alternatively, according to the claimed invention, the spring/height compensator are 3D printed on the top metal preform 43 to 45 (e.g. Mo, Cu, Al) which is then inserted together with preform 43 to 45 during assembly. The spring 29 is made e.g. of Inconel by 3D printing/additive manufacturing combined with an additional electrical conductive path. Alternatively, the spring 29 is made of conductive high strength Cu alloy by 3D printing for achieving both mechanical and electrical functions.

While the disclosure is amenable to various modifications and alternative forms, specifics thereof have been shown by way of example in the Figures and will be described in detail. It should be understood, however, that the intention is not to limit the disclosure to the particular embodiments described. On the contrary, the intention is to cover all modifications, equivalents, and alternatives falling within the scope of the appended claims.

### Reference Signs

- 10: power module
- 11, 11': first plate
- 12, 12': second plate
- 13 to 18, 13': power semiconductor body
- 19: first surface
- 20: second surface
- 23 to 28, 23': flexible structure
- 29, 29': spring
- 30: coil
- 31, 32: end plate
- 33 to 38: conducting part
- 43 to 45: preform
- 51 to 56: spring washer
- 70: arrangement
- 71: power module
- 72: fixation layer
- 101: first providing process
- 102: second providing process
- 103: arrangement process
- 104: additive manufacturing process
- 105: stack forming process
- 106: third providing process
- 107: attachment process
- 108: fixation process

## Claims

1. A method for producing a power module (10),
wherein the method comprises:
- providing a first plate (11),
- providing a second plate (12),
- arranging a first number N of power semiconductor bodies (13 to 15) on the first plate (11),
- providing a first number N of preforms (43 to 45),
- providing a first number N of flexible structures (23 to 25), and
- forming a stack comprising, in this order, the first plate (11), the first number N of power semiconductor bodies (13 to 15), the first number N of preforms (43 to 45), the first number N of flexible structures (23 to 25) and the second plate (12), wherein
- the first number N of flexible structures (23 to 25) are additive manufactured on the first number N of preforms (43 to 45),
- wherein the first number N is greater than 1, and
- wherein the first number N of flexible structures (23 to 25) are configured to compensate height differences of the first number N of the power semiconductor bodies (13 to 15) .

2. The method of claim 1, wherein the first number N of flexible structures (23 to 25) are additive manufactured as springs (29).

3. The method of claim 2, wherein the springs (29) have a form of a coil (30) or of a stack of spring washers (51 to 56).

4. The method of one of claims 1 to 3, wherein the first number N of flexible structures (23 to 25) are additive manufactured as porous structures or hollow structures.

5. The method of one of claims 1 to 4, wherein the first number N of flexible structures (23 to 25) are additive manufactured by using a non-conductive material.

6. The method of one of claims 1 to 4, wherein the first number N of flexible structures (23 to 25) are additive manufactured by using an austenitic nickel-chromium-based alloy.

7. The method of one of claims 1 to 4, wherein the first number N of flexible structures (23 to 25) are additive manufactured by using an electrically conductive material which is a metal or a metal alloy.

8. The method of any one of claims 1 to 7, wherein the method further comprises providing a first number N of conducting parts (33 to 35) which are arranged in the stack to connect the second plate (12) to the first number N of semiconductor bodies (13 to 15) or to the first number N of preforms (43 to 45).

9. A power module (10), comprising a stack comprising, in this order, a first plate (11), a first number N of power semiconductor bodies (13 to 15), a first number N of performs (43 to 45), a first number N of flexible structures (23 to 25) and a second plate (12), wherein the first number N of flexible structures (23 to 25) are additive manufactured on the first number N of performs (43 to 45), wherein the first number N is greater than 1, and wherein the first number N of flexible structures (23 to 25) are configured to compensate height differences of the first number N of the power semiconductor bodies (13 to 15).

## Patentansprüche

1. Verfahren zum Herstellen eines Leistungsmoduls (10),
wobei das Verfahren Folgendes umfasst:
- Bereitstellen einer ersten Platte (11),
- Bereitstellen einer zweiten Platte (12),
- Anordnen einer ersten Anzahl N von Leistungshalbleiterkörpern (13 bis 15) auf der ersten Platte (11),
- Bereitstellen einer ersten Anzahl N von Vorformlingen (43 bis 45),
- Bereitstellen einer ersten Anzahl N von flexiblen Strukturen (23 bis 25), und
- Bilden eines Stapels, der, in dieser Reihenfolge, die erste Platte (11), die erste Anzahl N von Leistungshalbleiterkörpern (13 bis 15), die erste Anzahl N von Vorformlingen (43 bis 45), die erste Anzahl N von flexiblen Strukturen (23 bis 25) und die zweite Platte (12) umfasst, wobei
- die erste Anzahl N von flexiblen Strukturen (23 bis 25) auf der ersten Anzahl N von Vorformlingen (43 bis 45) additiv gefertigt wird,
- wobei die erste Anzahl N größer als 1 ist, und
- wobei die erste Anzahl N von flexiblen Strukturen (23 bis 25) dazu ausgelegt ist, Höhenunterschiede der ersten Anzahl N von Leistungshalbleiterkörpern (13 bis 15) auszugleichen.

2. Verfahren nach Anspruch 1,
wobei die erste Anzahl N von flexiblen Strukturen (23 bis 25) als Federn (29) additiv gefertigt wird.

3. Verfahren nach Anspruch 2,
wobei die Federn (29) eine Form einer Spirale (30) oder eines Stapels von Federscheiben (51 bis 56) aufweisen.

4. Verfahren nach einem der Ansprüche 1 bis 3,
wobei die erste Anzahl N von flexiblen Strukturen (23 bis 25) als poröse Strukturen oder hohle Strukturen additiv gefertigt wird.

5. Verfahren nach einem der Ansprüche 1 bis 4,
wobei die erste Anzahl N von flexiblen Strukturen (23 bis 25) unter Verwendung eines nicht leitenden Materials additiv gefertigt wird.

6. Verfahren nach einem der Ansprüche 1 bis 4,
wobei die erste Anzahl N von flexiblen Strukturen (23 bis 25) unter Verwendung einer austenitischen Legierung auf Nickel-Chrom-Basis additiv gefertigt wird.

7. Verfahren nach einem der Ansprüche 1 bis 4,
wobei die erste Anzahl N von flexiblen Strukturen (23 bis 25) unter Verwendung eines elektrisch leitenden Materials additiv gefertigt wird, das ein Metall oder eine Metalllegierung ist.

8. Verfahren nach einem der Ansprüche 1 bis 7,
wobei das Verfahren ferner Bereitstellen einer ersten Anzahl N von leitenden Teilen (33 bis 35) umfasst, die in dem Stapel angeordnet werden, um die zweite Platte (12) mit der ersten Anzahl N von Halbleiterkörpern (13 bis 15) oder mit der ersten Anzahl N von Vorformlingen (43 bis 45) zu verbinden.

9. Leistungsmodul (10), umfassend
einen Stapel, der, in dieser Reihenfolge, eine erste Platte (11), eine erste Anzahl N von Leistungshalbleiterkörpern (13 bis 15), eine erste Anzahl N von Vorformlingen (43 bis 45), eine erste Anzahl N von flexiblen Strukturen (23 bis 25) und eine zweite Platte (12) umfasst, wobei die erste Anzahl N von flexiblen Strukturen (23 bis 25) auf der ersten Anzahl N von Vorformlingen (43 bis 45) additiv gefertigt wird, wobei die erste Anzahl N größer als 1 ist, und wobei die erste Anzahl N von flexiblen Strukturen (23 bis 25) dazu ausgelegt ist, Höhenunterschiede der ersten Anzahl N der Leistungshalbleiterkörper (13 bis 15) auszugleichen.

## Revendications

1. Procédé de fabrication d'un module de puissance (10),
le procédé comprenant :
- la fourniture d'une première plaque (11),
- la fourniture d'une deuxième plaque (12),
- l'agencement d'un premier nombre N de corps semiconducteurs de puissance (13 à 15) sur la première plaque (11),
- la fourniture d'un premier nombre N de préformes (43 à 45),
- la fourniture d'un premier nombre N de structures flexibles (23 à 25), et
- la formation d'un empilement comprenant, dans cet ordre, la première plaque (11), le premier nombre N de corps semiconducteurs de puissance (13 à 15), le premier nombre N de préformes (43 à 45), le premier nombre N de structures flexibles (23 à 25) et la deuxième plaque (12),
- le premier nombre N de structures flexibles (23 à 25) étant réalisées par fabrication additive sur le premier nombre N de préformes (43 à 45),
- le premier nombre N étant supérieur à 1, et
- le premier nombre N de structures flexibles (23 à 25) étant configurées pour compenser des différences de hauteur du premier nombre N des corps semiconducteurs de puissance (13 à 15).

2. Procédé selon la revendication 1,
le premier nombre N de structures flexibles (23 à 25) étant réalisées par fabrication additive sous forme de ressorts (29).

3. Procédé selon la revendication 2,
les ressorts (29) prenant la forme d'une spirale (30) ou d'un empilement de rondelles élastiques (51 à 56).

4. Procédé selon l'une quelconque des revendications 1 à 3,
le premier nombre N de structures flexibles (23 à 25) étant réalisées par fabrication additive sous forme de structures poreuses ou de structures creuses.

5. Procédé selon l'une quelconque des revendications 1 à 4,
le premier nombre N de structures flexibles (23 à 25) étant réalisées par fabrication additive à l'aide d'un matériau non conducteur.

6. Procédé selon l'une quelconque des revendications 1 à 4,
le premier nombre N de structures flexibles (23 à 25) étant réalisées par fabrication additive à l'aide d'un alliage austénitique à base de nickel-chrome.

7. Procédé selon l'une quelconque des revendications 1 à 4,
le premier nombre N de structures flexibles (23 à 25) étant réalisées par fabrication additive à l'aide d'un matériau électriquement conducteur qui est un métal ou un alliage métallique.

8. Procédé selon l'une quelconque des revendications 1 à 7,
le procédé comprenant en outre la fourniture d'un premier nombre N de pièces conductrices (33 à 35) qui sont agencées dans l'empilement pour connecter la deuxième plaque (12) au premier nombre N de corps semiconducteurs (13 à 15) ou au premier nombre N de préformes (43 à 45).

9. Module de puissance (10), comprenant un empilement comprenant, dans cet ordre, une première plaque (11), un premier nombre N de corps semiconducteurs de puissance (13 à 15), un premier nombre N de préformes (43 à 45), un premier nombre N de structures flexibles (23 à 25) et une deuxième plaque (12), le premier nombre N de structures flexibles (23 à 25) étant réalisées par fabrication additive sur le premier nombre N de préformes (43 à 45), le premier nombre N étant supérieur à 1, et le premier nombre N de structures flexibles (23 à 25) étant configurées pour compenser des différences de hauteur du premier nombre N des corps semiconducteurs de puissance (13 à 15).
